# EUROPEAN PATENT APPLICATION

(11) **EP 1 808 510 A2**
(43) Date of publication of application: **18.07.2007**
(21) Application number: 06125734.1
(22) Date of filing: 08.12.2006
(51) Int. Cl.: C23C 16/448, C23C 16/14

(54) **Thin film preparation apparatus**

(30) Priority: 17.01.2006 JP 2006008230
(71) Applicant: PhyzChemix Corporation, Minato-ku Tokyo 107-0052 (JP); Noda, Suguru, Koto-ku Tokyo 135-0022 (JP)
(72) Inventor: Jun, Keeyoung c/o Advanced Tech. Research Cntr, Yokohama-shi, Kanagawa 236-8515 (JP); Sakamoto, Hitoshi c/o Advanced Tech. Research Cntr, Yokohama-shi, Kanagawa 236-8515 (JP); Noda, Suguru, Tokyo 135-0022 (JP)
(74) Representative: Intes, Didier Gérard André

(57) **Abstract**

A thin film preparation apparatus performs film formation by supplying a precursor CuCl with increased supply accuracy and Cl*, from a material supply apparatus (6) outside a chamber (1) into the chamber, with the use of a member (14) to be etched, which has been temperature-controlled independently, and depositing a Cu component of the CuCl on a substrate (3), without complicating temperature control (simply by heating control by a heater), and without the influence of radiation from a plasma.

## Description

### Field of the Invention

This invention relates to a material supply apparatus and a thin film preparation apparatus. More particularly, the invention relates to those apparatuses which are useful when applied in allowing a halogen gas to act on a member to be etched, said member being formed of a metal forming a high vapor pressure halide, or a composite metal containing said metal, thereby forming a precursor as a halide of the metal, and adsorbing the precursor onto a substrate to form a predetermined thin metal film.

### Description of the Related Art

In the production of a semiconductor or the like, film formation using a plasma CVD (chemical vapor deposition) apparatus is currently known. The plasma CVD apparatus is an apparatus by which a gas of an organometallic complex or the like, introduced into a chamber to serve as a material for a film, is converted into the state of a plasma by a high frequency wave entered from a high frequency antenna so that a chemical reaction on the surface of a substrate is accelerated by active excited atoms in the plasma to form a thin metal film.

On the other hand, the inventors have developed a plasma CVD apparatus in which a member to be etched, the member comprising a metal component to be formed into a high vapor pressure halide for film formation, is installed within a chamber, then the member to be etched is etched with a plasma of a halogen gas to form a precursor as a halide of the metal component, and only the metal component of the precursor is deposited on a substrate (hereinafter, this plasma CVD apparatus is called the new-mode plasma CVD apparatus); and a film formation method using this apparatus (see, for example, Japanese Unexamined Patent Publication No. 2003-147534).

With the above-mentioned new-mode plasma CVD apparatus, the temperature of the substrate is controlled to a lower temperature than the temperature of the member to be etched, the member as a source of the metal for film formation, whereby the metal film is deposited on the substrate. If the member to be etched is Cu, and the halogen gas is Cl₂, for example, the member to be etched is controlled toahightemperature (e.g., 300 to 700°C),and the substrate is controlled to a low temperature (e.g., about 200°C), whereby a thin Cu film can be formed on the substrate.

Recent studies have shown that in the above new-mode plasma CVD apparatus, the precursor formed by etching of the member to be etched can be obtained, even without the generation of the halogen gas. That is, simply by allowing the halogen gas to act on the high temperature member to be etched, the member to be etched is thermally etched, with the result that the desired precursor can be obtained. After this precursor is adsorbed onto the substrate, the halogen is withdrawn, whereby a desired thin film of the metal can be deposited on the substrate.

In this case, it is a matter of course that the temperature of the substrate is controlled appropriately. In order to withdraw the halogen from the precursor adsorbed onto the substrate and deposit the desired thin metal film easily while ensuring a sufficient film formation speed and a sufficient film quality, it has been found to be important that radicals of the halogen be caused to act on the adsorbed precursor. The reactions taking place in this case can be expressed as follows:
1) Etching reaction: 2nCu + nCl₂ → 2CuₙClₙ (g)
2) Adsorption onto substrate: CuₙClₙ (g) → nCuCl (ad)
3) Film formation reaction: CuCl (ad) + Cl* → Cu + Cl₂↑ ... (1)

In the above reaction formulas, n denotes a natural number, Cl* denotes radicals of Cl, (g) denotes a gaseous state, and (ad) denotes an adsorbed state.

The essentially important factors for the above film formation reaction of the formula (1) are a flux of the precursor (e.g., CuCl) on the surface of the substrate, a flux of halogen radicals (e.g., Cl*) for reduction, and the temperature of the substrate. Furthermore, it is important to appropriately control the temperature of the member to be etched, because this temperature will act as a factor for controlling the flux of the precursor (e.g., CuCl).

In obtaining the precursor by thermal etching of the member, to be etched, with the halogen gas as described above, control of the film formation conditions is easy. This is because there is no need to generate a plasma for the etching of the member to be etched, and it is unnecessary to consider the thermal influence of the plasma. This suggests that optimal control of the film formation conditions can be exercised by independently controlling the respective factors contributing to the film formation reaction.

The present invention has been accomplished in the light of the above-mentioned new findings concerned with the new-mode CVD apparatus. It is an obj ect of the present invention to provide a material supply apparatus and a thin film preparation apparatus which can independently and easily control the temperature of a member to be etched, and can easily achieve the optimization of the film formation conditions.

### SUMMARY OF THE INVENTION

A first aspect of the present invention, for attaining the above obj ect, is a material supply apparatus, connected to a chamber accommodating a substrate, for supplying a gas serving as a material for a thin film into the chamber, the material supply apparatus comprising:
a member to be etched, the member being formed of a material containing an element capable of forming at least one high vapor pressure halide;
heating means for heating the member, to be etched, to a predetermined temperature; and
a material passage for bringing a halogen gas into contact with the member to be etched, which has been heated to the predetermined temperature, to form a gas of a precursor as a compound of said element and a halogen, and supplying the gas into the chamber.

In the first aspect of the invention, the halogen gas can be brought into contact with the member to be etched, which has been controlled to the predetermined temperature, within the material passage. Thus, the accuracy of supply of the precursor gas can be increased, and temperature control of the substrate to be relatively temperature-controlled becomes easy.

A second aspect of the present invention, for attaining the above obj ect, is a material supply apparatus, connected to a chamber accommodating a substrate, for supplying a gas serving as a material for a thin film into the chamber, and supplying radicals for deposition of the thin film into the chamber, the material supply apparatus comprising:
a member to be etched, the member being formed of a material containing an element capable of forming at least one high vapor pressure halide;
heating means for heating the member, to be etched, to a predetermined temperature;
a material passage for bringing a halogen gas into contact with the member to be etched, which has been heated to the predetermined temperature, to form a gas of a precursor as a compound of the element and a halogen, and supplying the gas into the chamber; and
a radical passage for bringing the halogen gas into contact with the heating means to obtain halogen gas radicals, and supplying the halogen gas radicals into the chamber.

In the second aspect of the invention, the halogen gas can be brought into contact with the member to be etched, which has been controlled to the predetermined temperature, within the material passage. Thus, the accuracy of supply of the precursor gas can be increased, and the halogen gas radicals can be supplied from the radical passage into the chamber. Hence, the supply accuracy for the precursor gas can be increased, and the supply of the halogen gas radicals from outside the chamber becomes possible, and thus the influence of radiation by plasma can be eliminated.

A third aspect of the invention is the material supply apparatus according to the second aspect, further comprising: an outer cylinder for forming the radical passage; a concentric inner cylinder provided on an inner periphery of the outer cylinder; a hot wire provided as heating means between the outer cylinder and the inner cylinder; and the member to be etched, the member being formed in a tubular shape on an inner periphery of the inner cylinder, and wherein the halogen gas is supplied to a space between the outer cylinder and the inner cylinder and to an interior of the inner cylinder, whereby the inner cylinder supplying the gas of the precursor into the chamber serves as the material passage, and the space between the outer cylinder and the inner cylinder supplying the halogen gas radicals into the chamber serves as the radical passage.

In the third aspect of the invention, the gas of the precursor and the halogen gas radicals can be supplied from the concentric nozzle, and the concentration control of the gas of the precursor can be easily performed by controlling the length of the nozzle and the concentration of the halogen gas. Furthermore, the radiation from the hot wire is present only in the axial direction of the nozzle, so that the influence of the radiation of the hot wire can be minimized.

A fourth aspect of the invention is the material supply apparatus according to the third aspect, further comprising: a concentric second outer cylinder provided on an outer periphery of the outer cylinder; and a working gas radical passage, defined between the outer cylinder and the second outer cylinder, for flowing a working gas to obtain working gas radicals, and supplying the working gas radicals into the chamber.

In the fourth aspect of the invention, the working gas radicals can be supplied from the working gas radical passage into the chamber. Thus, oxygen radicals or nitrogen radicals for oxidation treatment or nitration treatment can be supplied from a single nozzle.

A fifth aspect of the invention is the material supply apparatus according to the third aspect, further comprising: a concentric second outer cylinder provided on an outer periphery of the outer cylinder; a second member to be etched, the second member being provided between the outer cylinder and the second outer cylinder and formed of a material containing an element capable of forming at least one high vapor pressure halide; and a second material passage for bringing a halogen gas into contact with the second member to be etched, which has been heated to the predetermined temperature, to form a gas of a precursor as a compound of the element and a halogen, and supplying the gas into the chamber, the second material passage being defined between the outer cylinder and the second outer cylinder.

In the fifth aspect of the invention, the gas of the precursor formed from the second member to be etched can be supplied from the second material passage. Thus, the precursor comprising a different type of element can be supplied from a single nozzle.

A sixth aspect of the present invention, for attaining the above object, is a thin film preparation apparatus, comprising:
a tubular chamber accommodating a substrate;
the material supply apparatus according to the first aspect;
halogen radical generation means for generating halogen radicals within the chamber; and
temperature control means for controlling a temperature of the substrate to a relatively low predetermined temperature to adsorb the gas of the precursor from the material supply apparatus to the substrate, and allow the halogen radicals to act on the precursor kept adsorbed to the substrate, thereby reducing the precursor to deposit the element as a component of the precursor on the substrate for performing predetermined film formation.

In the sixth aspect of the invention, the precursor with increased supply accuracy of the gas can be supplied into the chamber, and the element component of the precursor can be deposited on the substrate for film formation, without complicating temperature control by the temperature control means.

A seventh aspect of the present invention, for attaining the above object, is a thin film preparation apparatus, comprising:
a tubular chamber accommodating a substrate;
the material supply apparatus according to the second or third aspect; and
temperature control means for controlling a temperature of the substrate to a relatively low predetermined temperature to adsorb the gas of the precursor from the material supply apparatus to the substrate, and allow the halogen radicals to act on the precursor kept adsorbed to the substrate, thereby reducing the precursor to deposit the element as a component of the precursor on the substrate for performing predetermined film formation.

In the seventh aspect of the invent ion, the precursor with increased supply accuracy of the gas, and the halogen gas radicals from the radical passage outside the chamber can be supplied into the chamber, and the element component of the precursor can be deposited on the substrate for film formation, without complicating temperature control by the temperature control means, and without the influence of radiation from a plasma.

An eighth aspect of the invention is the thin film preparation apparatus according to the sixth or seventh aspect, further comprising a plurality of the material supply apparatuses.

In the eighth aspect of the invention, the gas of the precursor is supplied from the plurality of material supply apparatuses, so that uniform gas supply can be performed.

A ninth aspect of the invention is the thin film preparation apparatus according to the seventh aspect, further comprising: plural pairs of the material supply apparatuses; and control means for rendering element components of the member to be etched in the respective pairs different, and selectively supplying the halogen gas to the respective pairs independently of each other pair to deposit the different element components in a stacked state on the substrate.

In the ninth aspect of the invention, selective supply control by the control means makes it possible to prepare a thin film having different element components deposited in a stacked state.

A tenth aspect of the invention is the thin film preparation apparatus according to the seventh aspect, further comprising: plural pairs of the material supply apparatuses; and control means for rendering element components of the member to be etched in the respective pairs different, and supplying the halogen gas to the respective pairs in supply amounts independent of each other pair to deposit the different element components in graded proportions on the substrate.

In the tenth aspect of the invention, supply control involving independent supply amounts by the control means makes it possible to prepare a thin film having different element components deposited in graded proportions.

The material supply apparatus of the present invention can supply the precursor while increasing the accuracy of supply of the gas. The material supply apparatus can also supply the halogen radicals while increasing the accuracy of gas supply.

The thin film preparation apparatus of the present invention can supply the precursor with increased supply accuracy of the gas into the chamber, and deposit the element component of the precursor on the substrate for film formation, without complicating temperature control by the temperature control means. The thin film preparation apparatus can also supply the precursor with increased supply accuracy of the gas, and the halogen gas radicals from the radical passage outside the chamber into the chamber, and deposit the element component of the precursor on the substrate for film formation, without complicating temperature control by the temperature control means, and without the influence of radiation by a plasma.

Accordingly, the temperature of the member to be etched can be controlled independently and easily, thus easily achieving optimization of the film formation conditions.

### BRIEF DESCRIPTION OF THE DRAWINGS

For a more complete understanding of the present invention and the advantages thereof, reference is now made to the following descriptions in conjunction with the accompanying drawings.
Fig. 1 is a schematic side view of a thin film preparation apparatus equipped with a material supply apparatus according to a first embodiment of the present invention.
Fig. 2 is a sectional view of the material supply apparatus.
Fig. 3 is a view taken on line III-III in Fig. 2.
Fig. 4 is a schematic side view of a thin film preparation apparatus according to a second embodiment of the present invention.
Fig. 5 is an external appearance view of a ceiling member.
Fig. 6 is a schematic side view of a thin film preparation apparatus according to a third embodiment of the present invention.
Fig. 7 is a schematic side view of a thin film preparation apparatus according to a fourth embodiment of the present invention.
Fig. 8 is a sectional view of a material supply apparatus according to another embodiment of the present invention.
Fig. 9 is a schematic side view of a thin film preparation apparatus equipped with a material supply apparatus according to a further embodiment of the present invention.
Fig. 10 is a sectional view of the material supply apparatus according to the further embodiment of the present invention.

### DESCRIPTION OF THE PREFERRED EMBODIMENTS

Embodiments of the present invention will now be described in detail with reference to the accompanying drawings.

### <First Embodiment>

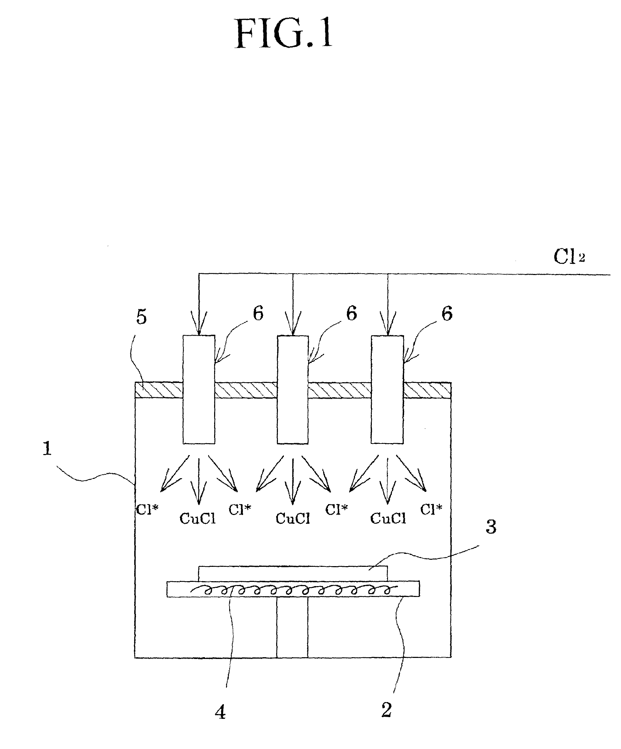

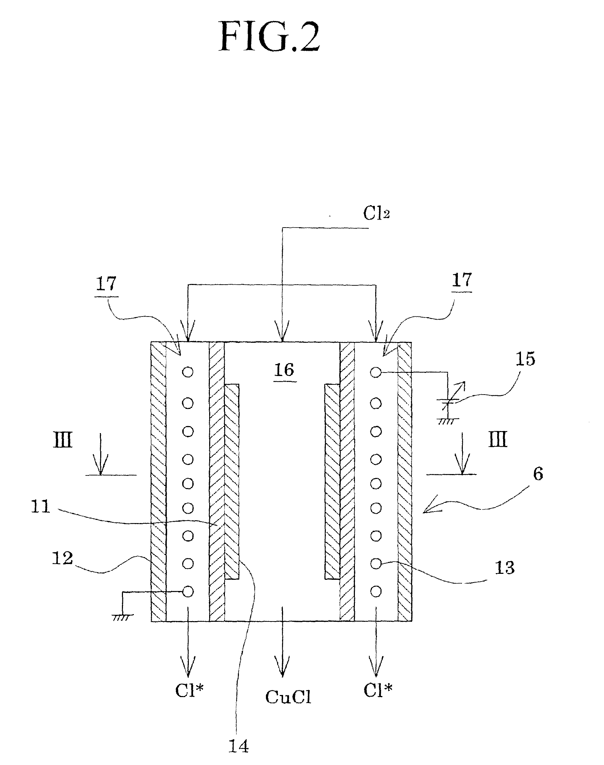

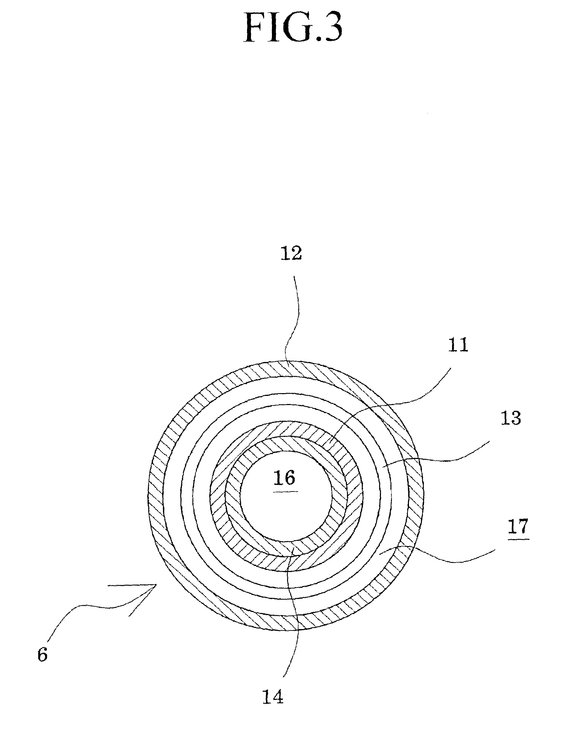

Fig. 1 is a schematic side view of a thin film preparation apparatus equipped with a material supply apparatus according to a first embodiment of the present invention. Fig. 2 is a sectional view of the material supply apparatus. Fig. 3 is a view taken on line III-III in Fig. 2.

As shown in Fig. 1, a susceptor 2 is provided in a lower portion of a chamber 1 formed in a cylindrical shape and made of, for example, a ceramic (an insulating material), and a substrate 3 is placed on the susceptor 2. A heater 4 is provided in the susceptor 2, and the susceptor 2 is controlled to a predetermined temperature (for example, a temperature at which the substrate 3 is maintained at 100°C to 300°C) by the heater 4. The shape of the chamber is not limited to the cylindrical shape, but a rectangular chamber, for example, can be applied.

The upper surface of the chamber 1 defines an opening portion, and the opening portion is closed with a ceiling plate 5 as a plate made of an insulating material (for example, a ceramic). A plurality of (three in the illustrated embodiment) material supply apparatuses 6 are provided at the ceiling plate 5, and a gas of a precursor serving as a material for a thin film and radicals for deposition of the thin film are supplied from the material supply apparatuses 6 into the chamber 1. Since a plurality of material supply apparatuses 6 are provided, the gas of the precursor and the radicals can be supplied in a uniform state into the chamber 1.

The gas of the precursor {for example, a gas of a precursor of a compound of copper (Cu) which can form a high vapor pressure halide, and chlorine (Cl₂) asahalogen: CuCl} to be adsorbed to the substrate 3, and Cl radicals (Cl*) as halogen radicals, which act on CuCl kept adsorbed to the substrate 3 to reduce CuCl, are supplied from the material supply apparatuses 6 into the chamber 1, although details will be mentioned later.

As a result of the supply of CuCl and Cl* into the chamber 1, CuCl is adsorbed to the substrate 3 maintained at a relatively low temperature (forexample, 100°C to 300°C), and Cl* act on CuCl kept adsorbed to the substrate 3 to reduce CuCl to deposit a Cu component on the substrate 3, thereby performing film formation.

The material supply apparatus 6 will be described based on Figs. 2 and 3.

As shown in the drawings, the material supply apparatus 6 is disposed in a concentric configuration. For example, the material supply apparatus 6 is furnished with an inner cylinder 11 and an outer cylinder 12, each formed of quartz. A hot wire 13 formed of, say, tungsten is disposed, as a heating means, between the outer cylinder 12 and the inner cylinder 11. A member 14 to be etched, which is formed in a cylindrical shape, is provided on the inner periphery of the inner cylinder 11. The member 14 to be etched is formed of a metal which can produce a high vapor pressure halide containing a metal component to be formed into a film. That is, if a thin Cu film is to be formed, for example, a precursor CuCl containing Cu is to be produced.

The interior of the inner cylinder 11 defines a material passage 16, and a passage defined between the inner cylinder 11 and the outer cylinder 12 and accommodating the hot wire 13 is used as a radical passage 17. The material passage 16 and the radical passage 17 are supplied with a chlorine gas (Cl₂ gas: a Cl₂ gas diluted with He to a chlorine concentration of 50% or lower, preferably to about 10%) which is a halogen gas.

The hot wire 13 inside the radical passage 17 has a heat release value controlled (for example, to 1500°C) by adjusting electrical energy supplied to a power source 15, so that the member 14 to be etched is heated to a desired temperature (for example, 400°C to 1000°C). Since the member 14 to be etched is heated to the desired temperature, contact of the Cl₂ gas with the heated member 14 to be etched results in thermal etching. When the desired temperature is set at, for example, 400°C to 1000°C, an adequate amount of the precursor CuCl necessary for film formation is produced.

The temperature of the member 14 to be etched is controlled by the hot wire 13 independently of the temperature of the substrate 3, so that the temperature control can be exercised meticulously and highly accurately, leading to an increased supply accuracy. Thus, when the substrate 3 is to be controlled to a relatively low temperature, it suffices to use a simple heating device on the susceptor 2. Hence, the temperature control function of the susceptor 2 can be simplified.

In the radical passage 17, the Cl₂ gas contacts the hot wire 13 to cause the reaction Cl₂ → 2Cl* by thermal dissociation, thus forming Cl*.

The precursor CuCl and Cl* produced by the material supply apparatus 6 in this manner are supplied into the chamber 1.

With the above-described material supply apparatus 6, the hot wire 13 having the heat release value controlled is provided in the radical passage 17 defined between the inner cylinder 11 and the outer cylinder 12, and the Cl₂ gas is supplied to the radical passage 17. As a result, contact between the Cl₂ gas and the hot wire 13 can take place reliably to increase the dissociation rate of the Cl₂ gas. Since the material supply apparatus 6 is formed in a double-pipe configuration, moreover, the gas of the precursor CuCl and Cl* can be supplied through the concentric nozzle, and the supply of Cl* from outside the chamber 1 can be performed, so that the influence of radiation by a plasma can be eliminated. Also, the concentration control of the precursor CuCl can be easily performed by controlling the length of the nozzle and the concentration of the Cl₂ gas. Furthermore, the radiation from the hot wire 13 is present only in the axial direction of the nozzle, so that the influence of the radiation of the hot wire 13 can be minimized.

A mode of film formation in the above thin film preparation apparatus will be described below.

The Cl₂ gas, adjusted to a predetermined state by a flow control device (not shown), is fed to the plurality of material supply apparatuses 6. The member 14 to be etched has been heated to a desired temperature by the hot wire 13 installed inside the radical passage 17. In the material passage 16, therefore, the heated member 14 to be etched is brought into contact with the Cl₂ gas, and thermally etched thereby to produce the precursor CuCl. In the radical passage 17, on the other hand, the Cl₂ gas contacts the hot wire 13 to form Cl* by thermal dissociation.

The precursor CuCl and Cl* produced in the material supply apparatus 6 are supplied into the chamber 1, and the precursor CuCl is transported to the substrate 3 controlled to a lower temperature than that of the member 14 to be etched, and is adsorbed to the substrate 3. Cl* supplied into the chamber 1 acts on the precursor CuCl adsorbed to the substrate 3 to reduce CuCl, thereby depositing Cu on the substrate 3.

Accordingly, the precursor CuCl with increased supply accuracy and the Cl* from the radical passage 17 outside the chamber 1 are supplied into the chamber 1, and the Cu component contained in the CuCl can be deposited on the substrate 3 to carry out film formation, without complicating temperature control (simply by exercising heating control by the heater 4), and without influence of radiation by a plasma.

### <Second Embodiment>

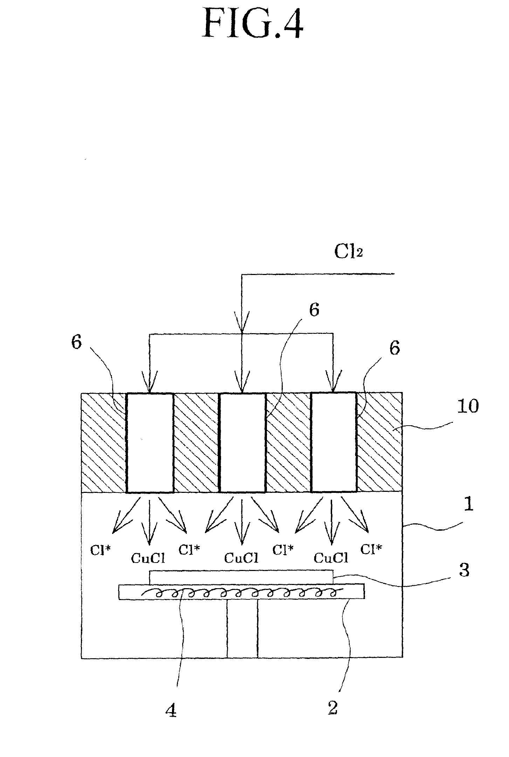

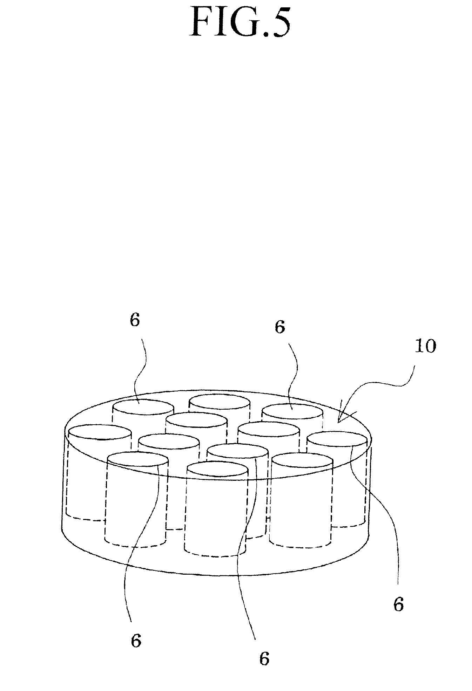

Fig. 4 schematically shows the side of a thin film preparation apparatus according to a second embodiment of the present invention. Fig. 5 shows the external appearance of a ceiling member. The same members as those in the first embodiment shown in Figs. 1 to 3 are assigned the same numerals as those in the first embodiment, and duplicate explanations are omitted.

As shown in the drawings, the upper surface of a chamber 1 defines an opening portion, and the opening portion is closed with a flat columnar ceiling member 10 made of an insulating material (for example, a ceramic) . In the ceiling member 10, a plurality of material supply apparatuses 6, each in the same configuration as that in the first embodiment, are provided integrally with the ceiling member 10. The length of the ceiling member 10 and the nozzle length of the material supply apparatus 6 are the same in dimension. Other features and the process of film formation are the same as those in the first embodiment.

By providing the material supply apparatuses 6 integrally with the ceiling member 10, uniform processing can be performed, even when film formation is carried out for a substrate 3 having a large area. Maintenance or replacement of the material supply apparatus 6 can be performed easily by detaching the ceiling member 10. Even when a different metal is to be deposited as a film, the material supply apparatuses 6 can be replaced simultaneously by replacing the ceiling member 10. Thus, other processing can be performed after making preparations in a short time.

### <Third Embodiment>

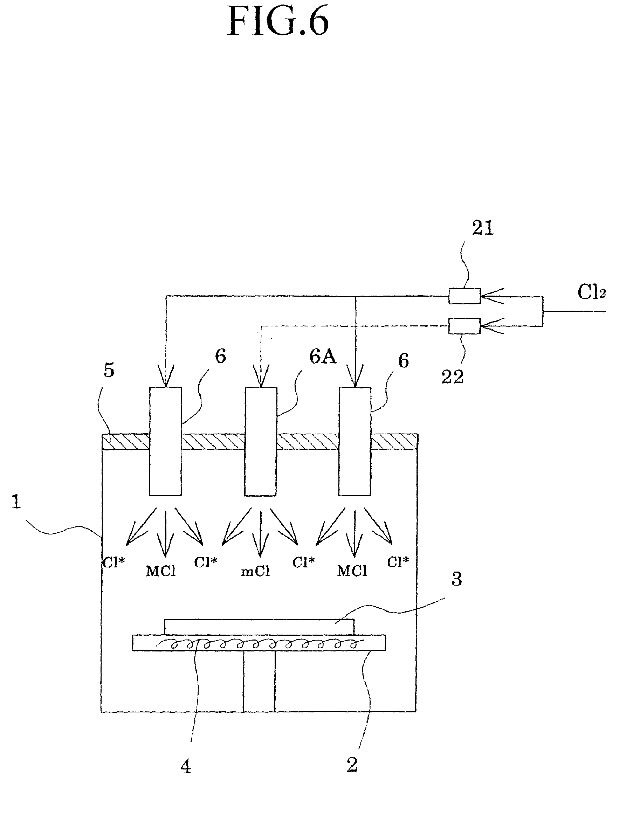

Fig. 6 schematically shows the side of a thin film preparation apparatus according to a third embodiment of the present invention. The same members as those in the first embodiment shown in Figs. 1 to 3 are assigned the same numerals as those in the first embodiment, and duplicate explanations are omitted.

The upper surface of a chamber 1 defines an opening portion, and the opening portion is closed with a ceiling plate 5 as a plate made of an insulating material (for example, a ceramic). A plurality of (three in the illustrated embodiment) material supply apparatuses 6, each in the same configuration as that in the first embodiment, are provided at the ceiling plate 5, and a gas of a precursor serving as a material for a thin film and radicals for deposition of the thin film are supplied from the material supply apparatuses 6 into the chamber 1. The material supply apparatuses 6 include pairs of apparatuses 6 each equipped with the member 14 to be etched which is shown in Figs. 2 and 3, and pairs of apparatuses 6A each equipped with the member to be etched which is formed of a different material.

The gas of the precursor (for example, a gas of a precursor of a compound of copper (Cu) which can form a highvaporpressurehalide, and chlorine (Cl₂) asahalogen: calledMCl) to be adsorbed to the substrate 3, and Cl radicals (Cl*) as halogen radicals, which act on MCl kept adsorbed to the substrate 3 to reduce MCl, are supplied from the material supply apparatuses 6 into the chamber 1, as in the first embodiment. The material supply apparatuses 6A are each provided with a different member (element m) to be etched, instead of the member 14 to be etched which is made of Cu. The gas of the precursor (for example, a gas of a precursor of a compound of other element m which can form a high vapor pressure halide, and chlorine (Cl₂) as a halogen: mCl) to be adsorbed to the substrate 3, and Cl radicals (Cl*) as halogen radicals, which act on mCl kept adsorbed to the substrate 3 to reduce mCl, are supplied from the material supply apparatuses 6A into the chamber 1.

The pairs of the material supply apparatuses 6 are supplied with the Cl₂ gas via a nozzle switch 21 as a control means, while the pairs of the material supply apparatuses 6A are supplied with the Cl₂ gas via a nozzle switch 22 as a control means. The nozzle switches 21, 22 are selectively turned on and off, whereby the Cl₂ gas is selectively supplied to the material supply apparatuses 6, 6A.

Other features and the process of film formation are the same as those in the first embodiment.

With the above-described thin film preparation apparatus, thin M films and thin m films are alternately deposited in a stacked state by selectively turning the nozzle switches 21, 22 on and off. Accordingly, a thin film of an alloy comprising different element components deposited in a stacked state can be prepared.

### <Fourth Embodiment>

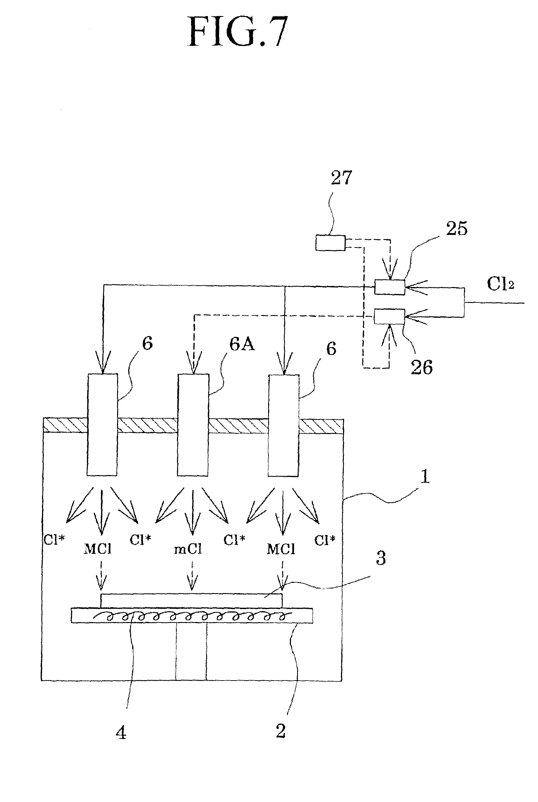

Fig. 7 schematically shows the side of a thin film preparation apparatus according to a fourth embodiment of the present invention. The same members as those in the first embodiment shown in Figs. 1 to 3, and the same members as those in the third embodiment shown in Fig. 6 are assigned the same numerals as those in these embodiments, and duplicate explanations are omitted.

The upper surface of a chamber 1 defines an opening portion, and the opening portion is closed with a ceiling plate 5 as a plate made of an insulating material (for example, a ceramic). A plurality of (three in the illustrated embodiment) material supply apparatuses 6, each in the same configuration as that in the first embodiment, are provided at the ceiling plate 5, and a gas of a precursor serving as a material for a thin film and radicals for deposition of the thin film are supplied from the material supply apparatuses 6 into the chamber 1. The material supply apparatuses 6 include pairs of apparatuses 6 each equipped with the member 14 to be etched which is shown in Figs. 2 and 3, and pairs of apparatuses 6A each equipped with the member to be etched which is formed of a different material.

The gas of the precursor (for example, a gas of a precursor of a compound of copper (Cu) which is an element capable of forming a high vapor pressure halide, and chlorine (Cl₂) as a halogen: called MCl) to be adsorbed to the substrate 3 , and Cl radicals (Cl* ) as halogen radicals, which at least act on MCl kept adsorbed to the substrate 3 to reduce MCl, are supplied from the material supply apparatuses 6 into the chamber 1 , as in the first embodiment. The material supply apparatuses 6A are each provided with a different member (element m) to be etched, instead of the member 14 to be etched which is made of Cu. The gas of the precursor (for example, a gas of a precursor of a compound of other element m which can form a high vapor pressure halide, and chlorine (Cl₂) as a halogen: mCl) to be adsorbed to the substrate 3, and Cl radicals (Cl*) as halogen radicals, which at least act on mCl kept adsorbed to the substrate 3 to reduce mCl, are supplied from the material supply apparatuses 6A into the chamber 1.

The pairs of the material supply apparatuses 6 are supplied with the Cl₂ gas via a flow controller 25 as a control means, while the pairs of the material supply apparatuses 6A are supplied with the Cl₂ gas via a flow controller 26 as a control means. The flow controllers 25, 26 have flow rates of the Cl₂ gas arbitrarily controlled under a command from a controller 27 as a control means, and supply the Cl₂ gas to the material supply apparatuses 6, 6A in independent supply amounts.

Other features and the process of film formation are the same as those in the first embodiment.

With the above-described thin film preparation apparatus, the flow controllers 25, 26 are arbitrarily controlled under the command from the controller 27, whereby the flow rates of the Cl₂ gas are controlled to independent supply amounts, with the result that thin M films and thin m films are deposited in arbitrary graded proportions. Accordingly, it becomes possible to prepare a thin film of an alloy comprising different element components deposited in graded proportions.

### <Fifth Embodiment>

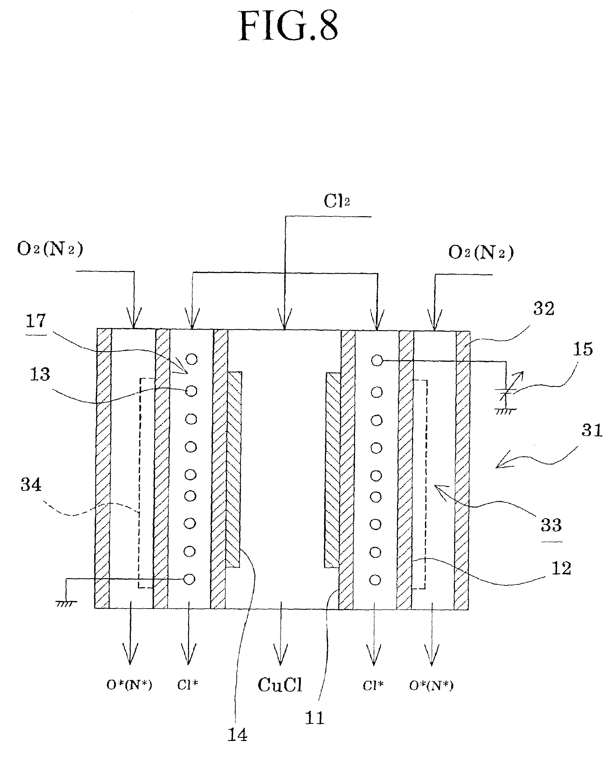

Fig. 8 shows a section of a material supply apparatus according to another embodiment of the present invention. The same members as those in the material supply apparatus 6 shown in Figs. 2 and 3 are assigned the same numerals as used there, and duplicate explanations are omitted.

A material supply apparatus 31 according to the present embodiment has a configuration in which a second concentric outer cylinder 32 is provided on the outer periphery of the outer cylinder 12 of the material supply apparatus 6 shown in Figs. 2 and 3. A working gas radical passage 33 is defined between the outer cylinder 12 and the second outer cylinder 32. The interior of the working gas radical passage 33 is heated with a hot wire 13, and the working gas radical passage 33 is supplied with an oxygen-containing gas or a nitrogen-containing gas as a working gas, so that O* or N* is formed by thermal dissociation. A hot wire for thermally dissociating the working gas can be independently provided for the working gas radical passage 33.

The material supply apparatus 31 supplies a precursor CuCl and Cl* from a radical passage 17, as in the first embodiment, and also supplies O* or N* from the working gas radical passage 33. Thus, the material supply apparatus 31 allows O* or N* to act on the Cu component deposited on the substrate 3 (see Fig. 1), thereby enabling an oxide film or a nitride film to be prepared.

In this manner, working gas radicals (O* or N*) can be supplied from the working gas radical passage 33 into the chamber, so that oxygen radicals or nitrogen radicals can be supplied from a single nozzle.

As indicated by dotted lines in Fig. 8, the working gas radical passage 33 can be caused to act as a second material passage, the second material passage can accommodate a second member 34 to be etched which contains an element component different from that of the member 14 to be etched, and a Cl₂ gas can be supplied to the second material passage to bring the Cl₂ gas into contact with the second member 34 to be etched which has been heated by the hot wire 13, thereby forming a gas of a precursor of a compound.

By so doing, the precursor gas produced from the second member 34 to be etched can be supplied from the second material passage. Thus, the precursor of the different element can be supplied from the single nozzle.

In addition, it is possible to take a measure such that a heating means for independently heating the second member 34 to be etched is provided on the outside of the second outer cylinder 32, and the placement of the hot wire 13 is changed to the outside of the outer cylinder 12 so that the member 14 to be etched, and the second member 34 to be etched are heated to the desired temperature.

### <Sixth Embodiment>

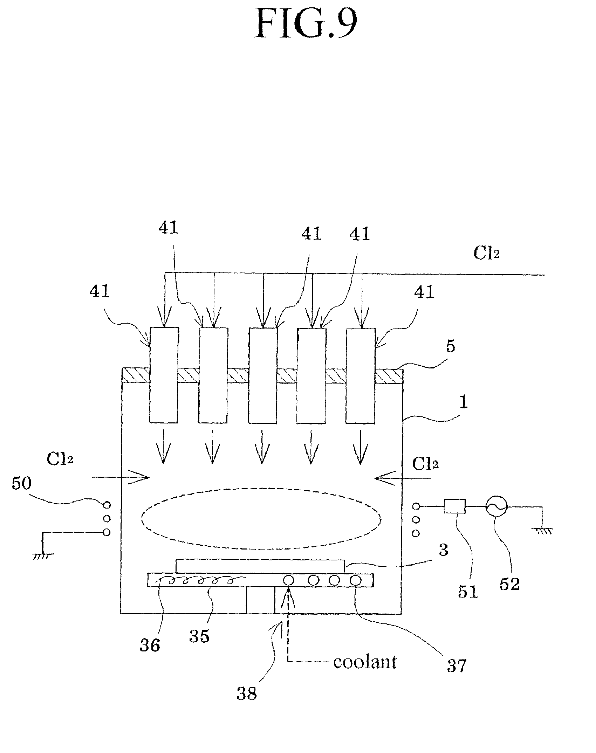

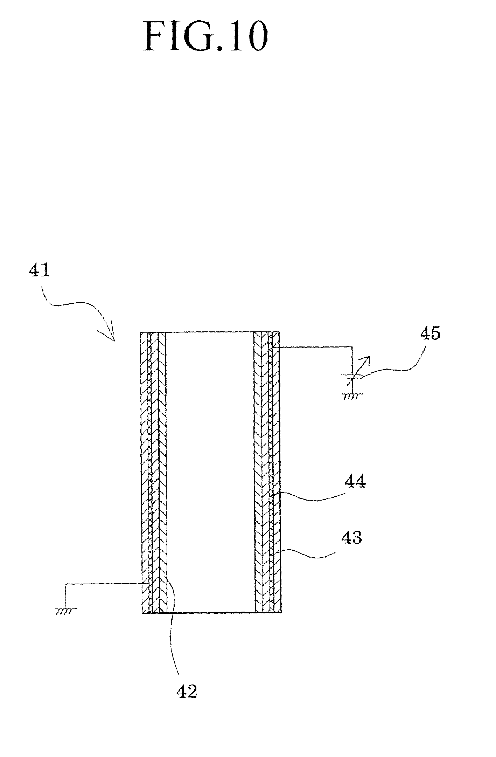

Fig. 9 schematically shows the side of a thin film preparation apparatus equipped with a material supply apparatus according to a further embodiment of the present invention. Fig. 10 shows a section of the material supply apparatus. The same members as those in the first embodiment shown in Figs. 1 to 3 are assigned the same numerals as those in the first embodiment, and duplicate explanations are omitted.

As shown in Fig. 9, a susceptor 35 is provided in a lower portion of a chamber 1 formed in a cylindrical shape and made of, for example, a ceramic (an insulating material), and a substrate 3 is placed on the susceptor 35. The susceptor 35 is provided with a temperature control means 38 equipped with a heater 36 and a coolant flowing means 37, and the susceptor 35 is controlled to a predetermined temperature (for example, a temperature at which the substrate 3 is maintained at 100°C to 300°C) by the temperature control means 38. The shape of the chamber is not limited to the cylindrical shape, but a rectangular chamber, for example, can be applied.

The upper surface of the chamber 1 defines an opening portion, and the opening portion is closed with a ceiling plate 5 as a plate made of an insulating material (for example, a ceramic). A plurality of (five in the illustrated embodiment) material supply apparatuses 41 are provided at the ceiling plate 5, and a gas of a precursor serving as a material for a thin film are supplied from the material supply apparatuses 41 into the chamber 1. Since the plurality of the material supply apparatuses 41 are provided, the gas of the precursor can be supplied in a uniform state into the chamber 1.

The gas of the precursor (for example, a gas of a precursor of a compound of copper (Cu) which is an element capable of forming a high vapor pressure halide, and chlorine (Cl₂) as a halogen: CuCl) to be adsorbed to the substrate 3 is supplied from the material supply apparatuses 41 into the chamber 1, although details will be mentioned later.

A coiled plasma antenna 50 is provided on the outer periphery of the chamber 1 at a site close to the susceptor 35, and a matching instrument 51 and a power source 52 are connected to the plasma antenna 50 to supply power. The interior of the chamber 1 is supplied with a chlorine gas (Cl₂ gas: a Cl₂ gas diluted with He to a chlorine concentration of 50% or lower, preferably to about 10%), and the plasma antenna 50 is supplied with power, whereby a Cl₂ gas plasma is generated to generate Cl radicals (Cl*) as halogen radicals (halogen radical generation means).

As a result of the supply of CuCl into the chamber 1, CuCl is adsorbed to the substrate 3 maintained at a relatively low temperature (for example, 100°C to 300°C) . Upon generation of Cl* within the chamber 1, Cl* acts on CuCl kept adsorbed to the substrate 3 to reduce CuCl and deposit a Cu component on the substrate 3, thereby performing film formation.

A shower head can be provided above supply ports of the chamber 1 for the Cl₂ gas to transport CuCl toward the substrate 3 uniformly. By providing the shower head, it becomes possible to decrease the number of the material supply apparatuses 41, and supply a large amount of CuCl from the single material supply apparatus 41 for uniform supply of CuCl.

The material supply apparatus 41 will be described based on Fig. 10.

As shown in the drawing, the material supply apparatus 41 has a tubular gas introduction pipe 43, and the inner periphery of the gas introduction pipe 43 defines a material introduction passage. A tubular member 42 to be etched is provided on the inner periphery of the gas introduction pipe 43 . The member 42 to be etched is formed of a metal which can produce a high vapor pressure halide containing a metal component to be formed into a film. A resistance heater 44 as a heating means is provided inside the gas introduction pipe 43. By adjusting electrical energy supplied to a power source 45, the heat release value of the resistance heater 44 is controlled (for example, to 1,500°C), thereby heating the member 42 to be etched to a desired temperature (for example, 400 to 1,000°C). The material introduction passage is supplied with a chlorine gas (Cl₂ gas: a Cl₂ gas diluted with He to a chlorine concentration of 50% or lower, preferably to about 10%) which is a halogen gas.

Since the member 42 to be etched is heated to the desired temperature, supply of the Cl₂ gas to the material introduction passage results in contact of the Cl₂ gas with the heated member 42 to be etched, causing thermal etching. When the desired temperature is set at, for example, 400°C to 1000°C, an adequate amount of the precursor CuCl necessary for film formation is produced. By changing the length of the member 42 to be etched and the concentration of chlorine, concentration control of the material is exercised.

With the material supply apparatus 41, the temperature of the member 42 to be etched is controlled by the resistance heater 44 independently of the temperature of the substrate 3, so that the temperature control can be exercised meticulously and highly accurately, leading to an increased supply accuracy. Thus, the Cl₂ gas can be brought into contact with the member 42 to be etched, which has been controlled to the predetermined temperature, within the material supply passage. Hence, the supply accuracy of CuCl can be increased, and the temperature control of the substrate 3, which is relatively temperature-controlled, also becomes easy. Furthermore, the double-tube structure facilitates the replacement of the member 42 to be etched.

A mode of film formation in the above thin film preparation apparatus will be described below.

The Cl₂ gas, adjusted to a predetermined state by a flow control device (not shown), is fed to the plurality of material supply apparatuses 41. The member 42 to be etched has been heated to a desired temperature by the resistance heater 44 installed inside the material supply passage. In the material supply passage (inside the gas introduction pipe 43), therefore, the heated member 42 to be etched is brought into contact with the Cl₂ gas, and thermally etched thereby to produce the precursor CuCl.

Within the chamber 1, on the other hand, the Cl₂ gas is supplied, and power supply is performed for the plasma antenna 50, whereby a Cl₂ gas plasma is generated to produce Cl radicals (Cl*) as a halogen radical.

The precursor CuCl produced in the material supply apparatus 41 is supplied into the chamber 1, and the precursor CuCl is transported to the substrate 3 controlled to a lower temperature than that of the member 42 to be etched, and is adsorbed to the substrate 3. Cl* formed in the chamber 1 acts on the precursor CuCl adsorbed to the substrate 3 to reduce CuCl, thereby depositing Cu on the substrate 3.

Accordingly, the precursor CuCl by the member 42 to be etched, which has been independently temperature-controlled, is supplied into the chamber 1. Thus, the precursor CuCl with increased supply accuracy can be obtained. Moreover, the site of production of the precursor CuCl and the site of reduction and film formation are separated from each other. Thus, the apparatus with satisfactory controllability and involving a simple mechanism can be constructed.

The present invention can be utilized in the fields of industries involving a material supply apparatus and a thin film preparation apparatus which allow a halogen gas to act on a member to be etched, the member formed of a metal forming a high vapor pressure halide, or a composite metal containing the metal, thereby forming a precursor as a halide of the metal, and adsorb the precursor onto a substrate to form a predetermined thin metal film.

The embodiments of the present invention have been described above, but the invention is not limited to these embodiments. It should be understood that the invention can be subject to changes, substitutions or alterations without departing from the spirit and scope of the invention as defined by the appended claims.

## Claims

1. A material supply apparatus (6), connected to a chamber (1) accommodating a substrate (3), for supplying a gas serving as a material for a thin film into the chamber, the material supply apparatus (6) comprising:
a member (14) to be etched, said member being formed of a material containing an element capable of forming at least one high vapor pressure halide;
heating means for heating the member, to be etched, to a predetermined temperature; and
a material passage (16) for bringing a halogen gas into contact with said member (14) to be etched, which has been heated to the predetermined temperature, to form a gas of a precursor as a compound of said element and a halogen, and supplying the gas into the chamber (1).

2. A material supply apparatus (6), connected to a chamber (1) accommodating a substrate (3), for supplying a gas serving as a material for a thin film into the chamber, and supplying radicals for deposition of the thin film into the chamber, the material supply apparatus (6) comprising:
a member (14) to be etched, said member being formed of a material containing an element capable of forming at least one high vapor pressure halide;
heating means for heating the member, to be etched, to a predetermined temperature;
a material passage (16) for bringing a halogen gas into contact with the member to be etched, which has been heated to the predetermined temperature, to form a gas of a precursor as a compound of the element and a halogen, and supplying the gas into the chamber; and
a radical passage (17) for bringing the halogen gas into contact with the heating means to obtain halogen gas radicals, and supplying the halogen gas radicals into the chamber.

3. The material supply apparatus according to claim 2, further comprising:
an outer cylinder (12) for forming the radical passage (17);
a concentric inner cylinder (11) provided on an inner periphery of the outer cylinder;
a hot wire (13) provided as heating means between the outer cylinder and the inner cylinder; and
the member (14) to be etched, said member being formed in a tubular shape on an inner periphery of the inner cylinder, and
wherein the halogen gas is supplied to a space between the outer cylinder and the inner cylinder and to an interior of the inner cylinder, whereby the inner cylinder (11) supplying the gas of the precursor into the chamber (1) serves as the material passage (16), and the space between the outer cylinder (12) and the inner cylinder (11) supplying the halogen gas radicals into the chamber serves as the radical passage (17).

4. The material supply apparatus according to claim 3, further comprising:
a concentric second outer cylinder (32) provided on an outer periphery of said outer cylinder (12); and
a working gas radical passage (33), defined between the outer cylinder and the second outer cylinder, for flowing a working gas to obtain working gas radicals, and supplying the working gas radicals into the chamber.

5. The material supply apparatus according to claim 3, further comprising:
a concentric second outer cylinder (32) provided on an outer periphery of said outer cylinder (12);
a second member (34) to be etched, said second member being provided between the outer cylinder (12) and the second outer cylinder (32) and formed of a material containing an element capable of forming at least one high vapor pressure halide; and
a second material passage for bringing a halogen gas into contact with the second member to be etched, which has been heated to the predetermined temperature, to form a gas of a precursor as a compound of said element and a halogen, and supplying the gas into the chamber, the second material passage being defined between the outer cylinder (12) and the second outer cylinder (32).

6. A thin film preparation apparatus, comprising:
a tubular chamber (1) accommodating a substrate (3);
the material supply apparatus according to claim 1;
halogen radical generation means for generating halogen radicals within the chamber; and
temperature control means for controlling a temperature of the substrate to a relatively low predetermined temperature to adsorb the gas of the precursor from the material supply apparatus to the substrate, and allow the halogen radicals to act on the precursor kept adsorbed to the substrate, thereby reducing the precursor to deposit the element as a component of the precursor on the substrate for performing predetermined film formation.

7. A thin film preparation apparatus, comprising:
a tubular chamber (1) accommodating a substrate (3) ;
the material supply apparatus according to claim 2 or 3; and
temperature control means for controlling a temperature of the substrate to a relatively low predetermined temperature to adsorb the gas of the precursor from the material supply apparatus to the substrate, and allow the halogen radicals to act on the precursor kept adsorbed to the substrate, thereby reducing the precursor to deposit the element as a component of the precursor on the substrate for performing predetermined film formation.

8. The thin film preparation apparatus according to claim 6 or 7, further comprising a plurality of said material supply apparatuses.

9. The thin film preparation apparatus according to claim 7, further comprising:
plural pairs of said material supply apparatuses; and
control means for rendering element components of the member to be etched in the respective pairs different, and selectively supplying the halogen gas to the respective pairs independently of each other pair to deposit the different element components in a stacked state on the substrate.

10. The thin film preparation apparatus according to claim 7, further comprising:
plural pairs of the material supply apparatuses; and
control means for rendering element components of the member to be etched in the respective pairs different, and supplying the halogen gas to the respective pairs in supply amounts independent of each other pair to deposit the different element components in graded proportions on the substrate.
